Europäisches Patentamt

(19) European Patent Office

Office européen des brevets

(11) Publication number: **0 062 967**
**B1**

(12) **EUROPEAN PATENT SPECIFICATION**

(45) Date of publication of patent specification: **04.12.85**

(21) Application number: **82301189.5**

(22) Date of filing: **09.03.82**

(51) Int. Cl.⁴: **D 21 H 1/12, B 44 C 1/00**

(54) Method for producing a bright metallized foil or board.

(30) Priority: **11.03.81 US 242424**

(43) Date of publication of application:
**20.10.82 Bulletin 82/42**

(45) Publication of the grant of the patent:
**04.12.85 Bulletin 85/49**

(84) Designated Contracting States:
**AT BE CH DE FR GB IT LI LU NL SE**

(56) References cited:
**DE-A-2 856 510**
**GB-A- 449 782**
**GB-A-2 006 109**
**US-A-3 235 395**
**US-A-3 463 659**
**US-A-4 153 494**
**US-A-4 250 209**

(73) Proprietor: **TRANSFER PRINT FOILS, INC**
**9 Cotters Lane**
**East Brunswick New Jersey 08816 (US)**

(72) Inventor: **Parker, Harry A.**
**130 Colchester Road**
**Murray Hill New Jersey 07974 (US)**

(74) Representative: **Denmark, James**
**c/o Bailey Walsh & Co. 5 York Place**
**Leeds LS1 2SD Yorkshire (GB)**

Courier Press, Leamington Spa, England.

## Description

The present invention relates generally to the production of metalized paper or board products, and particularly to a transfer technique for applying the metal coating to the paper or board substrate, which results in the preparation of a metalized product having improved brilliance and hardness and scratch resistance.

In general, the use of transfer techniques to apply metallic coatings to substrates, such as fabric, leather or plastic surfaces, is well known. Thus, the technique of gold leaf transfer was utilized in the 19th century by bookbinders, who employed gold foil transfer sheets to attach gold letters to leather bindings. The transfer sheets comprised a waxed carrier web over which a sheet of gold foil was placed, the gold foil coated on its free side with a heat-activated adhesive layer. In practice, the transfer sheet was hot pressed with a heated die to adhere the metal foil to the leather, and the carrier was thereafter stripped away. The waxy parting layer than was coated initially over the carrier, served to maintain the gold leaf in position on the carrier prior to its transfer, and to permit release of the carrier after the gold had been affixed to the leather.

In recent times, the advent of vapor deposition of metals, such as aluminum and the like, has spurred further interest in the use of this metalization technique for the preparation of a variety of metalized substrates. Thus, techniques of both direct and transfer coating have been attempted on a variety of base materials, including porous materials such as cloth, leather, paper and the like. The potential usefulness for these metalized substrates is enormous, as, for example, metalized paper or board is broadly used for decorative packaging, and other applications where the appearance of a metal surface is desired.

A number of techniques for the metalization of paper and board are known and are disclosed in the art. Thus, U.S. Patent Number 3,043,728, to Stauffer, discloses a specific apparatus and associated method for preparing a metalized paper product, which relies on the initial application of the metalized layer to a drum and the transfer of the metal layer to the paper substrate which has been previously directly coated with an adhesive. U.S. Patent Number 3,235,395, to Scharf, discloses a transfer metalization technique that patentee states is applicable to paper. A heat or pressure sensitive adhesive is utilized in this method.

Other transfer metalization techniques are disclosed in U.S. Patent Numbers 2,703,772, to Keithly, 3,080,270, to Lorenz, and U.S. Patent Number 3,589,962, to Bonjour. All of these techniques, however, relate primarily to metalization of fabrics, and make secondary reference to metalization of paper, and in the instance of Lorenz, suggests that an initial coating must be placed on the substrate prior to the transfer of the metal layer thereto.

Direct metalization techniques for the preparation of coated paper products are disclosed in U.S. Patent Number 3,463,659, to Dragoon et al., and U.S. Patent Number 3,730,752, to Guajardo Garza et al. In both instances, however, the patentees suggest that a preliminary coating or base coating of the paper substrate is necessary to facilitate application of the metal layer.

U.S. Patent Number 4,153,494, to Oliva, discloses a metalization technique which when carefully reviewed, appears closer to the ancient art of gold leaf transfer. In particular, Oliva utilizes a varnish, interposed between the metal layer and the substrate to be coated, such as paper or board, so that the metal layer will be adhesively bound thereto. Oliva may apply the varnish either directly to the substrate to be coated, or to the metal layer which is subsequently transferred to the substrate.

U.S. Patent No. 4,250,209 and U.K. Patent Application No. 2,006,109 each discloses that a metalized layer is applied to a substrate by applying a release coat to a carrier, vacuum depositing the metalised film on the release coat, applying adhesive to the metalized film and contacting the adhesive with the substrate. The carrier is subsequently stripped away from the release coat wall remains with the metalized film and substrate layer.

Finally DE—A—2856510 discloses a process wherein a tie coating is applied to a metalised carrier film before bonding to a paper substrate and stripping away the carrier film.

Some of the prior art techniques discussed above, possess certain basic drawbacks, which most of the patenteees above already acknowledge. In particular, paper and board substrates are porous materials having residual moisture. The process of applying the metalized surface directly to the paper or board base is complicated by the tendency of the base to exhibit outgassing during the application of the metal coating, that causing coating discontinuities that result in the formation of a dull or matte finish to the metal surface.

Alternatively, when the metal layer is formed on a carrier and a transfer to the paper or board base is attempted, the conditions under which such transfer is usually conducted, i.e. pressure and/or elevated temperature, results in the undesirable elimination of all moisture from the porous paper or board base, with the result that the paper or board base subsequently absorbs moisture from the atmosphere and develops surface discontinuities, known as "curling", "cockling", and "crowning", all of which subsequently detract from the smooth metalized appearance desired in the product.

In similar fashion, the direct application of adhesives to the paper or board base, as disclosed in certain of the prior art references, causes the same surface discontinuities to develop and the resulting metalized products exhibit the same deficiences. Attempts to overcome this problem have centered around efforts to apply printer coatings by techniques that subsequently surface treat the paper or board base in an attempt to assure a smooth, sealed surface for the application of the metal layer. Such processes, however, are uneconomical and frequently unreliable, and have enjoyed limited commercial success, if any.

A need therefore exists for the development of a simple, inexpensive process that results in the preparation of a metalized paper or board product offering uniform, improved brilliance and smoothness, together with durability and hardness in use.

In accordance with the present invention this is achieved by the special coupling of the substrate with the metal layer, and in accordance with the present invention there is provided a method for producing a metalized paper or board product having improved surface smoothness and brightness, and resistance to fracture upon flexure, comprising:

A. providing a carrier film;

B. applying a lacquer coating to said carrier film, said lacquer coating to serve as the outer, protective surface of said metalized paper or board product and capable of adherently bonding to a deposited metal layer, as well as receiving other display material that may be printed or otherwise coated on the outer surface thereof;

C. depositing a thin, continuous and adherent metal layer on said lacquer coating;

D. applying a wet adhesive emulsion coating at the side of the metal layer opposite the lacquer;

E. feeding the carrier of Step D and a base selected from paper and board, into the nip of a pair of pressure rollers, shortly after the performance of Step D, so that said adhesive coating remains wet as it contacts and penetrates said base; and

F. separating said carrier from said base, after their emergence from said pressure rollers, with said base having adherently bound thereto a multi-layered article comprising an outer coating of said lacquer, a next adjacent coating of the said metal layer, and an adhesive bond disposed between said metal layer and said base; characterised in that a tie coating is applied between steps C and D, in that the tie coating is applied to the metal layer and said adhesive is applied to the tie coating for the enhancement of the hardness and scratch resistance of the resulting paper or board product.

Preferably, the carrier may be a conventional material such as a polyester sheet or strip, the lacquer coating may be selected from cellulosic resins, such as nitrocellulose, or vinyl resins, such as vinylacetatevinylchloride copolymers, and other equivalent materials. The vapor deposited metal is preferably aluminium, and the tie coat is preferably aliphatic polyurethane compositions. The adhesive may comprise a polymeric emulsion including various vinyl polymers such as polyvinylalcohol and polyvinylacetate homopolymers and copolymers as well as polyacrylic compositions. Preferably, the adhesive coating has an acidic pH, and more particularly a pH ranging from about 4.5 to about 5.5.

The present method involves essentially a "wet process" in that the adhesive emulsion is wet as it contacts the paper or board base, and remains so for a time sufficient to penetrate the paper or board base during the bonding of the metalized layer thereto. The penetration of the paper or board base by the wet adhesive in conjunction with the use of the coat is a feature of the invention that is particularly noteworthy in view of the prior art caveats against such a technique, as described earlier. Metalized paper or board products prepared by the present technique have uniformly smooth surfaces, and do not exhibit the prior art defects of "cockling", "crowning" and the like, despite the penetration of the wet adhesive into the base.

The adhesive bond formed between the base and the metalized composite is such that the carrier may be simply stripped away after passage of the base and carrier through the pressurized rollers. There is no need for a post-curing operation, or the application of heat together with pressure, as utilized in some of the prior art. The present method, by contrast, may be practiced with an optional final step wherein the already formed metalized product is heated to achieve further drying, by, for example, exposure of the coated product to a temperature of about 121°C (250°F), for a period of about one minute.

Accordingly, it is a principal object of the present invention to provide a method for the rapid and inexpensive manufacture of a metalized paper or board product.

It is a further object of the present invention to provide a method as aforesaid that results in the preparation of a product having improved surface smoothness, brilliance and hardness.

It is a yet further object of the present invention to provide a method as aforesaid which utilizes a transfer technique employing a wet adhesive without adversely effecting the coated paper or board base.

It is a still further object of the present invention to provide a method as aforesaid which does not require the imposition of a post-treatment to cure the adhesive binding the metalized layer to the base.

Other objects and advantages will become apparent to those skilled in the art from a review of the ensuring description which proceeds with reference to the following illustrative drawings.

Figure 1 is a schematic plan view sequentially illustrating the various steps of the present method.

Figure 2 is a schematic fragmentary sectional view partly in phantom, illustrating the various layers of the metalized paper or board product prepared in accordance with the present invention.

In its broadest aspect, the present invention comprises the preparation of a metalized paper or board product having improved surface smoothness and brightness, and resistance to fracture upon flexure. The method comprises providing and feeding a carrier film, applying a lacquer coating to the carrier film, the lacquer coating to serve as the outer, protective surface of the metalized paper or board product. The lacquer coating should preferably be capable of adherently bonding to a depositied metal layer, as well as receiving other display material that may be printed or otherwise coated on its outer surface.

After the application of the lacquer coating, a thin, continuous and adherent metal layer is deposited on the lacquer coating, to provide the brilliant metalized appearance to the resulting paper or board product. A tie coating preferably comprising a polyurethane composition, is thereafter applied to the outer surface of the metal layer, and is permitted to dry. Thereafter, an adhesive coating comprising a wet emulsion, is applied over the tie coating to prepare the composite structure for transfer.

The next step in the method comprises feeding the carrier prepared as described above, and a base such as paper or board into the nip of a pair of pressure rollers, with the surface of the carrier bearing the wet adhesive emulsion facing the paper or board base. As the carrier and the base are united between the rollers, the adhesive coating penetrates the base as it adheres thereto. Subsequently, the carrier may be stripped from the base, leaving the base having adherently bound thereto a multi-layerd article, comprising an outer coating of the lacquer, a next adjacent coating of the metal layer, a tie coating next adjacent to the metal layer and an adhesive bond disposed between the tie coating and the base.

The carriers useful in the present invention includes those materials conventionally employed, that may be capable of withstanding repeated use in accordance with the present method. Thus, the carrier should be capable of successive coating and stripping, and recoating without exhibiting deterioration during metalizing or under the tension of delamination during the release of the transferred composite to the base. Suitable materials employed in accordance with the present invention as the carrier, include polyester films, varaious cellulose derivatives, vinyl compounds, elastomers and others. Preferably, a polyester film is employed. While the thickness of the carrier is not critical, a thickness of 1 mil (25.4 μm) is preferred.

The lacquer coating useful in the present invention may be selected from a variety of materials capable of providing a durable outer surface for the coated paper or board product, that is receptive to printed, coated and embossed display material. The lacquer must also be capable of cleanly stripping away from the carrier in use, so that a smooth, continuous surface is left. A variety of lacquers are suitable for this purpose, and include cellulose derivatives such as nitrocellulose, and vinyl polymers, including vinylchloride and vinylacetate polymers and copolymers. In particular, a vinylchloride-vinylacetate copolymer may be utilized. The lacquer coat may be applied in various thicknesses, and is preferably applied in a thickness ranging from about 0.0005 to about 0.005 thousandths of an inch (0.0127 to 0.127 μm). The lacquer coat may be preferred with conventional organic solvents such as methyl ethyl ketone, ethyl alcohol, toluol and the like.

The lacquer coat may be clear, in the instance where it is desired to obtain a purely metallic appearance, or may be colored by incorporation of pigments, dyes and the like, to give various decorative appearances to the final paper or board product.

The application of the metal layer to the coated carrier may be accomplished by conventional techniques, and is preferably accomplished by vapor deposition. The invention does not relate to the manner in which the metal coating is applied per se, and thus the techniques of vapor deposition of metal as are known in the art, may be utilized herein, and such conventional techniques are incorporated herein by reference. As is known in the art, the number of metals that may be applied by this technique to form a tightly adherent, continuous coating is broad, and would include both precious and non-precious metals, such as gold, silver, tin, zinc, chromium and aluminum. In accordance with the present invention, aluminum is the preferred metal and is applied by vapor deposition to a thickness that may range, for example, up to about 7 mils (177.8 μm) or greater. The exact thickness of the layer is discretionary, and may vary with the intended application of the paper or board product.

The tie coating as noted earlier, provides improved hardness and scratch resistance to the paper or board product. Suitable tie coatings include polyurethane compositions, and in particular, flexible polyurethanes formed with a polyol and an aliphatic isocyanate. Naturally, polyurethanes produced by the reaction of a polyol with an aromatic iscoyanate such as toluene di-isocyanate, may be utilized as well, however, polyurethane compositions produced by the reaction of an aliphatic isocyanate with a polyol have been found to result in a tie coating having improved resistance to yellowing or aging.

The polyurethane compositions may possess coatings ranging in thickness from about 0.005 thousandths of an inch to about 0.008 thousandths of an inch (0.127 to 0.203 μm). The polyurethane tie coatings are particularly receptive and compatible with a subsequently applied emulsion adhesive, and thus favorably coact therewith, in addition to imparting improved hardness and scratch resistance to the resulting paper or board product.

The adhesive coating of the present invention is applied as a liquid emulsion and as noted earlier, is compatible with the tie coating so that the bond between the metallic layer and the base will be firmly formed. Suitable adhesives include vinyl polymers, such as vinylacetate homopolymers and copolymers, polyvinylalcohol emulsions, shellac emulsions and acrylic emulsions. In accordance with the present invention, the adhesive emulsion may preferably possess a pH in the acidic range, and more particularly a pH ranging from about 4.5 to 5.5. It has been found that the employment of an adhesive emulsion of this pH range reduces the incidence of attack and deterioration of the metal layer during the life of the paper or board product.

As noted earlier, the adhesive is applied as a wet emulsion, and the present process is accordingly characterized as a "wet process". By this it is meant that the adhesive remains wet from the time of its application, until it is applied against the adjacent surface of the paper or board base, as the base and the carrier are united between the nip of the pressure rollers. In this way, the wet adhesive emulsion may thoroughly penetrate the base, and preferably must do so, to assist in the formation of the improved bond between the metalized composite and the paper or board base that is characteristic of the present product. The ability of the present product to emerge from the pressure rollers in its completed form, without the exhibition of surface defects or dullness is one of the primary features of the present invention.

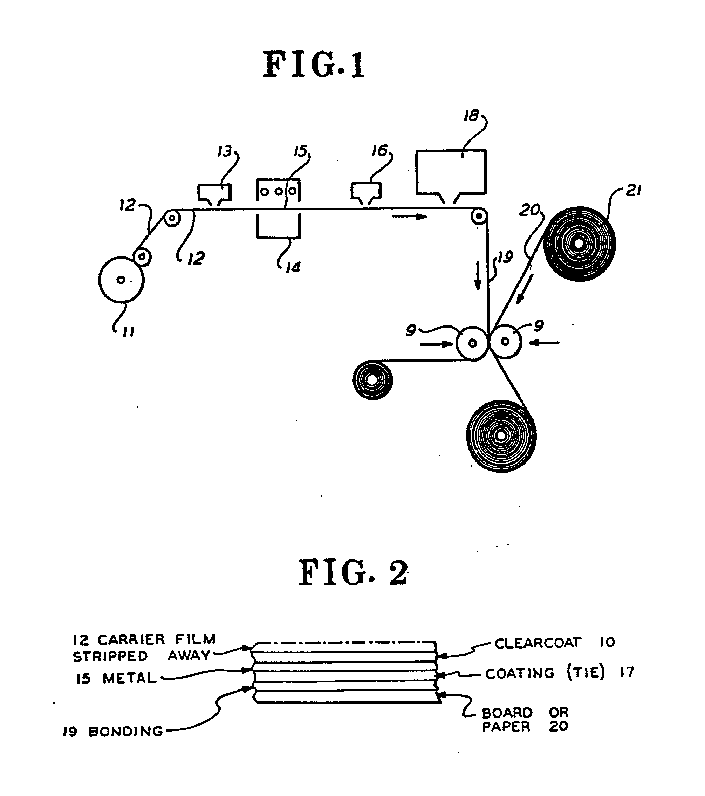

Referring now to Figure 1 and 2, the production of the paper or board products proceeds in the following manner. A supply roll 11 delivers a sheet, strip or film of a carrier 12 to a series of coaters. The carrier 12 may, as noted earlier, comprise a polyester film.

A lacquer coating 10 is then applied by coater 13, and may be applied to the thicknesses suggested earlier herein. Carrier 12 then passes through the vacuum furnance 14 where a vaporized metal layer 15, which may comprise aluminum, is condensed on its upper surface. The exact thickness of layer 15 may vary as indicated earlier.

Carrier 12 now bearing lacquer coating 10 and vaporized metal layer 15 thereover is then fed past a second coater 16 where a tie coat, preferably a polyurethane composition, is applied thereover. After the application of the tie coat, the carrier 12 passes to a coater 18 where an adhesive emulsion coat 19 is applied over the tie coat 17. The adhesive emulsion coat remains wet, as indicated earlier, and carrier 12 is then directed into the nip of opposed rollers 9, 9 simultaneously with the introduction of a sheet or strip of paper or board 20 from a supply roller 21 as illustrated. Thus, carrier 12 and paper or board 20 meet at the nip of rollers 9, 9, and the wet adhesive emulsion coat 19 makes contact with and thereafter penetrates the adjacent surface of the paper or board 20. At this point, the bond between the paper or board 20 and the multi-layered composite comprising the lacquer coating 10, the vaporized metal layer 15, the tie coat 17 and the adhesive emulsion coat 19 is complete, and the carrier 12 may be stripped away from the base so that it parts cleanly from lacquer coating 10 and may thereafter be retrieved for reuse in the present method. In such instance, carrier 12 may be a continuous band.

The paper or board base may be used in the form received, as prepared above, or may be given a heat treatment to hasten the drying of the adhesive coat 19. In such instance, the metalized paper or board product is heated in an oven at approximately 121°C (250°F) for about one minute. This heating step, however, is optional.

The resulting product exhibits improved brilliance and scratch resistance, and is capable of a variety of uses, including imprinting with colored inks, embossing and the like.

The following examples illustrate the preparation of certain of the coatings useful in the method of the present invention.

Example I

A lacquer coat was prepared having the following ingredients in the following amounts.

| Ingredients | Parts by weight |
| --- | --- |
| Nitrocellulose (1/2 second viscosity) (70% wet in alcohol- Hercules Powder Company) | 20 |
| Methyl ethyl ketone | 50 |
| Denatured ethyl alcohol | 30 |
| Total | 100 |

A second formulation was prepared with a vinyl polymer as follows:

| Ingredients | Parts by weight |
| --- | --- |
| Vinylacetate-vinylchloride copolymer (VAGH-Union Carbide Corp.) | 15 |
| Methyl ethyl ketone | 50 |
| Toluol | 35 |
| Total | 100 |

Example II

The tie coats were prepared from polyurethane materials and particularly a material identified such as Mobay Chemical-Desmocoll E 471, and Desmocoll E 477. Preferably, the tie coat is a flexible polyurethane derived from an aliphatic isocyanate and a polyol. (Desmocoll is a Registered Trade Mark).

Example III

Two formulations of adhesive coats were prepared which are preferably applied to a weight of approximately 3.5 pounds per 1500 square feet (15.6 N per 139.35 m$^2$). The coating compositions were as follows:

| Ingredients | Parts by weight |
|---|---|
| Vinyl alcohol emulsion (Franklin Chemical Industries-FH2) | 50 |
| Water | 50 |
| Total | 100 |

A second formulation was prepared as follows:

| Ingredients | Parts by weight |
|---|---|
| Polyvinylacetate homopolymer (Amsco Res 3 or Amsco Res 4 non-ionic manufactured by Union Chemical Company) | 50 |
| Water | 50 |
| Total | 100 |

The present disclosure is to be considered as in all respects illustrative and not restrictive, the scope of the invention being indicated by the appended cliams.

**Claims**

1. A method for producing a metalized paper or board product having improved surface smoothness and brightness, and resistance to fracture upon flexure, comprising:
A. providing a carrier film;
B. applying a lacquer coating to said carrier film, said lacquer coating to serve as the outer, protective surface of said metalized paper or board product and capable of adherently bonding to a deposited metal layer, as well as receiving other display material that may be printed or otherwise coated on the outer surface thereof;
C. depositing a thin, continuous and adherent metal layer on said lacquer coating;
D. applying a wet adhesive emulsion coating at the side of the metal layer opposite the lacquer;
E. feeding the carrier of Step D and a base selected from paper and board, into the nip of a pair of pressure rollers, shortly after the performance of Step D, so that said adhesive coating remains wet as it contacts and penetrates said base; and
F. separating said carrier from said base, after their emergence from said pressure rollers, with said base having adherently bound thereto a multi-layered article comprising an outer coating of said lacquer, a next adjacent coating of the said metal layer, and an adhesive bond disposed between said metal layer and said base; characterised in that a tie coating is applied between steps C and D, in that the tie coating is applied to the metal layer and said adhesive is applied to the tie coating for the enhancement of the hardness and scratch resistance of the resulting paper or board product.

2. The method of Claim 1 characterised in that the coated base of Step F is thereafter heated to dry said adhesive coating.

3. The method of Claim 2 characterised in that said coated base is heated at a temperature of about 121°C for about one minute.

4. The method of Claim 1 characterised in that said lacquer coating is colored.

5. The method of Claim 1 characterised in that said tie coating is a polyurethane coating.

6. The method of Claim 5 characterised in that said polyurethane coating is prepared with an aliphatic isocyanate.

7. The method of Claim 1 characterised in that said adhesive coating comprises a material selected from vinylacetate homopolymers, vinylacetate copolymers, shellac emulsions, polyvinylalcohol emulsions and acrylic emulsions.

8. The method of Claim 1 or 7 characterised in that said adhesive coating possesses an acidic pH.

9. The method of Claim 8 characterised in that said pH ranges from about 4.5 to about 5.5.

**Patentansprüche**

1. Verfahren zum Herstellen eines metallisierten Papier- oder Pappeproduktes mit verbesserter Oberflächerglätte und Glanz sowie Beständigkeit gegen Bruch beim Biegen, umfassend:
A. das Vorsehen eines Trägerfilms;
B. das Aufbringen eines Lacküberzuges auf den genannten Trägerfilm, welcher Lacküberzug als die äußere Schutzoberfläche des genannten metallisierten Papier- oder Pappeproduktes dient und haftend an eine abgeschiedene Metallschicht gebunden werden kann sowie anderes Schmuckmaterial aufnehmen kann, das auf die Außenfläche hievon aufgedruckt oder sonst aufgetragen werden kanne;
C. das Abscheiden einer dünnen, kontinuierlichen und haftenden Metallschicht auf dem genannten Lacküberzug;
D. das Auftragen eines feuchten Klebeemulsionsüberzuges an der dem Lack gegenüberliegenden Seite der Metallschicht;
E. das Zuführen das Trägers von Schritt D und einer Basis ausgewählt aus Papier und Pappe in den Spalt eines Druckwalzenpaares kurz nach der Durchführung von Schritt D, so daß der genannte Klebeüberzug feucht bleibt, wenn er die genannte Basis berührt und sie durchdringt; und
F. das Abtrennen des genannten Trägers von der genannten Basis nach ihrem Herauskommen aus den genannten Druckwalzen, wobei die genannte Basis daran haftend gebunden ein mehrschichtiges Erzeugnis aufweist, das aus einem äußeren Überzug des genannten Lacks, einem nächsten benachbarten Überzug der genannten Metallschicht und einer zwischen der Metallschicht und der genannten Basis befindlichen Klebebindung besteht, dadurch gekennzeichnet, daß ein Verbindungsüberzug zwischen den Schritten C und D angebracht wird, daß der Verbindungsüberzug auf die Metallschicht aufgetragen wird und der genannte Klebstoff zur Erhöhung der Härte und Kratzfestigkeit des resultierenden Papier- oder Pappeproduktes auf den Verbindungsüberzug aufgebracht wird.

2. Verfahren von Anspruch 1, dadurch gekennzeichnet, daß die beschichtete Basis von Schritt F danach zum Trocknen des genannten Klebeüberzuges erhitzt wird.

3. Verfahren nach Anspruch 2, dadurch gekennzeichnet, daß die beschichtete Basis während etwa 1 min auf etwa 121°C erhitzt wird.

4. Verfahren nach Anspruch 1, dadurch gekennzeichnet, daß der genannte Lacküberzug gefärbt wird.

5. Verafahren nach Anspruch 1, dadurch gekennzeichnet, daß der genannte Verbindungsüberzug ein Polyurethanüberzug ist.

6. Verfahren nach Anspruch 5, dadurch gekennzeichnet, daß der genannte Polyurethanüberzug mit einem aliphatischen Isocyanat hergestellt wird.

7. Verfahren nach Anspruch 1, dadurch gekennzeichnet, daß der genannte Klebeüberzug ein Material ausgewählt aus Vinylacetathomopolymeren, Vinylacetatcopolymeren, Shellac-Emulsionen, Polyvinylalkoholemulsionen und Acrylemulsionen umfaßt.

8. Verfahren nach Anspruch 1 oder 7, dadurch gekennzeichnet, daß der genannte Klebeüberzug einen sauren pH aufweist.

9. Verfahren nach Anspruch 8, dadurch gekennzeichnet, daß der genannte pH etwa 4,5 bis etwa 5,5 beträgt.

**Revendications**

1. Procédé de production d'un produit en papier ou en carton métallisé ayant un brillant, une égalité de surface et une résistance à la cassure par flexion améliorés, comprenant:

A—fournir un film de support;

B—appliquer un vernis sur ledit film de support, ledit vernis constituant la surface protectrice externe dudit produit en papier ou en carton métallisé et pouvant adhérer à une couche métallique déposée, ainsi que recevoir un autre matériau de présentation qui peut être imprimé ou enduit d'une autre façon sur sa surface externe;

C—déposer une fine couche métallique continue et adhérente sur ledit vernis;

D—appliquer un revêtement d'émulsion adhésive humide sur le côté de la couche métallique opposé au vernis;

E—amener le support de l'étape D et une base en papier ou en carton dans l'étranglement entre une paire de rouleaux de pression, peu après la mise en oeuvre de l'étape D, de sorte que ledit revêtement adhésif reste humide alors qu'il entre en contact avec ladite base et la pénètre; et

F—séparer ledit support de ladite base, après leur sortie desdits rouleaux de pression, un article à plusieurs couches adhérant à ladite base, ledit article comprenant un revêtement externe constitué dudit vernis, un revêtement adjacent suivant constitué de ladite couche métallique et une liaison adhésive disposée entre ladite couche métallique et ladite base, caractérisé en ce qu'un revêtement de liaison est appliqué entre les étapes C et D, en ce que le revêtement de liaison est appliqué à la couche métallique et en ce que ledit adhésif est appliqué au revêtement de liaison pour augmenter la dureté et la résistance aux éraflures du produit en papier ou en carton résultant.

2. Procédé selon la revendication 1, caractérisé en ce que la base enduite de l'étape F est ensuite chauffée de façon à sécher ledit revêtement adhésif.

3. Procédé selon la revendication 2, caractérisé en ce que ladite base enduite est chauffée à une température d'environ 121°C pendant environ 1 minute.

4. Procédé selon la revendication 1, caractérisé en ce que ledit vernis est coloré.

5. Procédé selon la revendication 1, caractérisé en ce que ledit revêtement de liaison est une revêtement de polyuréthane.

6. Procédé selon la revendication 5, caractérisé en ce que ledit revêtement de polyuréthane est préparé à partir d'un isocyanate aliphatique.

7. Procédé selon la revendication 1, caractérisé en ce que ledit revêtement adhésif comprend un matériau choisi parmi les homopolymères d'acétate de vinyle, les copolymères d'acétate de vinyle, les émulsions de shellac, les émulsions d'alcool polyvinylique et les émulsions acryliques.

8. Procédé selon la revendication 1 ou 7, caractérisé en ce que ledit revêtement adhésif possède un pH acide.

9. Procédé selon la revendication 8, caractérisé en ce que ledit pH est compris entre environ 4,5 et environ 5,5.

# FIG.1

# FIG. 2

12 CARRIER FILM STRIPPED AWAY ─────→

15 METAL ─────→

19 BONDING ─────

CLEARCOAT 10

COATING (TIE) 17

BOARD OR PAPER 20